# EUROPEAN PATENT SPECIFICATION

(11) **EP 1 017 263 B1**
(45) Date of publication and mention of the grant of the patent: **17.09.2003**
(21) Application number: 99310135.1
(22) Date of filing: 16.12.1999
(51) Int. Cl.: H05K 7/20, G06F 1/20

(54) **Computer cabinet design**
Design von Computergehäuse
Conception de boîtier d' ordinateur

(30) Priority: 30.12.1998 US 223002; 03.12.1999 US 453799
(43) Date of publication of application: 05.07.2000
(73) Proprietor: Koplin, Edward C., Baltimore, Maryland 21211 (US)
(72) Inventor: Koplin, Edward C., Baltimore, Maryland 21211 (US)
(74) Representative: Staudt, Hans-Peter, Dipl.-Ing.

(56) References cited:
- US-A- 3 348 609
- US-A- 4 016 357
- US-A- 4 458 296
- "ENCLOSURE COOLING WITH FANS AND FINS" MACHINE DESIGN,US,PENTON,INC. CLEVELAND, vol. 67, no. 2, 26 January 1995 (1995-01-26), pages 109-110, XP000501526 ISSN: 0024-9114

## Description

The present invention relates to cooling of equipment in cabinets and more particularly to integrate the cabinet cooling into a raised floor or overhead cooling system.

It has been found that cabinet cooling systems that are not integrated with a fault tolerant, concurrently maintainable and transparently expandable design of a raised floor or overhead cooling system cannot reasonably control overheating of equipment. The heat produced in some of the higher technology systems exceeds the capacity of systems currently available resulting in damage to high-tech computers and peripheral equipment.

Often, expensive, quality uninterruptable power systems (UPS) are installed for both the computer systems and cabinet fan powered cooling assemblies. Existing cabinet cooling technologies, waste available UPS power because methods do not exist to vary the fan energy as a percentage of the power required to cool the critical computer and other electronic equipment installed in the cabinets. Additionally, the typical cabinet fan is non-redundant and is sized to cool the maximum load projected for the cabinet, even though the average cabinet may only contain a fraction of the heat producing equipment that was considered for the fan selection.

A major problem develops in those systems which are initially sufficient to handle the heat loads expected, but must have cooling capacity increased without disturbing the installed heat producing equipment. There are many industries that cannot readily accept down time of equipment to accommodate changes; such as, railroads, production line control systems, financial markets, air travel reservation centers and the like.

Another problem is the industry practice to provide cuts in a raised floor that are left open with only a few square inches containing any cables or wires. Cooling air is drained from the raised floor unimpeded through the excessive cable openings, resulting in loss of air and static pressure that is needed for cooling elements or equipment in the cabinet overhead cooling is distributed from overhead ducts and the problem is that the room becomes cold, thus reducing the capacity of the cooling system.

In a large number of large installations, cabinets are set side-by-side with no walls in-between. The entire interior area thus created is treated in many respects as a single entity resulting in large amounts of fans used in the aggregate and wasted critical power. In these installations a fan or perhaps two are located in the top wall of the cabinets and may be programmed to a fixed speed. A cabinet with a large heat load may be positioned next to a cabinet with a small heat load and yet the fan associated with this later cabinet may be running at full speed. The usual procedure in such systems because there are separations between cabinets is to run with fans at a standard speed regardless of load which is very wasteful of critical power. It is to be noted that power is supplied for the computer and at most 10% should be used for cooling. Thus, every effort should be made to conserve power used for cooling.

The installations previously provided required the tiles of elevated floors to be cut at a cost of approximately $100/tile to accommodate the cabinets and provide adequate support. The cutting of the tiles, usually on the job, is time consuming and quite expensive. No attempt has been made to date to provide appropriate material to accommodate the floor to the cabinets or the cabinets to the floor.

Large losses of cooling energy are encountered through openings through which cables and wires are introduced into the cabinets. Inadequate use of masking or structural features to provide shielding is the rule.

An important failure of the prior systems is their failure to permit the system to be readily adjusted in the field to the environment. Openings cut in the field that were large enough for installers to work through, pull wires, etc. were grossly oversized for cooling. In many cases the cabinets were pre-wired and left unpowered, waiting months for operating load to materialize, yet the openings left by installers would not be closed. Any and all of the air passing through these access openings under the floor wasted cooling capacity and static pressure. They failed to a great extent to control properly cooling capacity, static pressure and to the extent controllable under very difficult procedures, often requiring a cabinet to be unloaded and tipped over for effecting control. The wasted cooling capacity issues could not be resolved even if other critical systems were adversely affected because the need for continuous data and telecommunications processing prevented any interruption to the operation of equipment in working cabinets. Retrofitting existing cabinets with on-line processing load is nearly impossible to accomplish without risk. Such latter procedure relates to the cooling capacity and pressure under tile floors and the need to insure, once installed, that each cabinet drain off minimum cooling air and produce minimum pressure drop.

It is an object of the present invention to avoid the necessity of custom cutting of floor tiles to accommodate equipment cabinets.

Another object of the invention is to employ barriers between cabinets to avoid interaction of cooling effects.

It is yet another object of the invention to provide equipment that permits convection cooling of components in a cabinet to reduce or eliminate the need for critical electrical power to operate cabinet cooling fans, or use forced cool air cooling or use of both types of cooling concurrently.

Yet another object of the invention is to provide members in the interior of a cabinet that prevent interference with the flow of cooling air from under the floor on which the cabinets are situated and members that prevent interface with flow into or out of the top of a cabinet.

It is still another object of the invention to permit cabinets having different power loads to be situated side-by-side without causing a cooling capacity conflict between adjacent cabinets.

An object of the invention is to control distribution of static pressure and cooling air from under the floor on which the cabinet is standing.

Another object of the invention is to be able to provide multiple installed fans where needed and to control the operation of the fans including disabling some or all to maintain a desired temperature.

Another object is to use fans that are small enough in size to allow multiple fans to fit on the top or the bottom of a standard sized cabinet for adequate capacity control, limiting the use of critical power yet still providing redundant fan operation.

Still another object of the invention is to provide visual and/or audible indications of the conditions in a cabinet.

Another object is to provide a network connection to monitor the cabinet cooling performance across a local area network (LAN), wide area network (WAN) or the Internet.

It is an object of the invention to prevent leakage of air to be used in cooling around cables bringing in power or control signals.

Still another object is to provide a method of field adjusting the wireway openings so that a cabinet can sit empty without wasting cooling airflow or static pressure, as the wireways remain closed while allowing easy field adjustments for wire and airflow once electronic equipment is installed into the cabinet.

Another object of the invention is to limit the use of critical power to that actually required to maintain temperature.

It is still another object of the invention to be able to accommodate vastly different cooling loads in adjacent cabinets.

Yet another object of the invention is to provide in the top of the cabinet accommodations for a plurality of panels that may accommodate fans, be blank panels, be panels for connection to forced air cooling supplies or large exhaust systems and highly perforated panels permitting ready air flow therethrough.

The cabinet of the preferred embodiment of the present invention has a top surface that can accommodate multiple insertable panels that may be blank plates, highly perforated laces, variable opening grommets, pipes to accept cooling, or exhaust air and/or fans. Multiple induction fans may be used and allow paralleling of the capacity incrementally to provide redundant fan operation as needed, while limiting UPS power. The bottom surface of the cabinet sits on tiles of a raised floor in one embodiment over an opening and has multiple adjustable grommets to control flow of cool air into the cabinet as needed. The shelves in the cabinet are all highly perforated, while simultaneously fabricated for adequate structural support, so that cool or ambient air may readily flow through the cabinet and out of the top. The door and perhaps back panel of the cabinet may also have controlled perforated regions. A highly perforated shelf installed at the factory is positioned a distance above the floor to prevent any equipment to be placed under the shelf so that flow through the grommets is not impeded. Cooling can also be provided by overhead ducts, but with the degree of cooling required for cabinets containing equipment that creates high temperatures, the room itself would be far too cool for comfort. A solution to the use of overhead ducts for cooling is to direct the cool air through small distribution ducts directly into the cabinets.

The cooling mechanism employed does not rely heavily on the pressurized air from under the floor. The mechanism relies in most instances on room air drawn into the cabinet by convection and/or a fan or fans located on the top of the cabinet. The cabinet resembles a stack with both convection currents and the fan inducing the air heated by the equipment to flow out of the top of the cabinet. In many instances the convection currents are sufficient to cool the equipment and the fan are used to break up conflicting convection flow patterns. The fan insures that the air flows around all of the equipment to carry off the heat. This feature is assisted by highly perforated shelves. If necessary, cooling air from under the floor may be admitted to the cabinet through grommets in the bottom of the cabinet controlling such flow. The flow of pressurized cool air into the cabinet is limited to that necessary to affect the desired cooling so as not to overload and possibly burn up the air conditioners supplying cool air under the floor.

The stack effect of the cabinets causes the heated air to rise well above the cabinets so that hot air exiting one cabinet does not flow around the air intake region of adjacent cabinets.

A slide damper in the door is held in an open, partially open, or closed position by nylon or other plastic non-electrically conductive hardware so that if screws, fasteners, plugs, etc. break loose as a result of vibration or use of the damper electrical equipment is not damaged. Also, the damper is fail safe; that is, if the screws, plugs, etc. holding the damper in a fully closed or partially open position, the damper fully opens and the equipment will not overheat. Further, the hardware employed is captive hardware such that only broken parts can fall in the cabinet. Under normal circumstances there are no loose parts. All components of the physical system are available from outside the cabinet so that tools are not required to be introduced into the cabinet eliminating the danger of damage to the equipment terminals or wires from the tools. The cabinet may be modified by adding or subtracting fans in the top of the cabinet, inserting or removing panels in the door or adjusting the slide damper in the door, all done externally of the cabinet equipment hardware shelves.

The panels in the front of the cabinet can be manufactured in a clear plexiglass so that lights and other status indicators on the computers are visible through the perforations and the clear blocking panel behind.

It is preferred that all six openings have fans installed at the factory and that temperature responsive controls be employed to control the speed of the fans. Such an arrangement provides maximum flexibility together with the ability to handle maximum as well as minimum heat loads. If for any reason a customer does not desire such an arrangement then a blank panel or panels can be inserted into the unused opening in the top wall to prevent flow of heated air in the room from flowing into the cabinets. As pointed out elsewhere if sufficient flow is induced in the cabinet then a perforated panel can be employed in one of the slots. The type of flow can be induced by convection cooling, then a perforated panel may be used alone or in conjunction with fans carefully adjusted. Cool air can be added from the floor to increase upward flow if the heat is such that the cool air can be heated sufficiently by the equipment to add to the induced flow from outside or is pulled up by fans on the top of the cabinet.

A temperature control and alarm system suitable for use in such a system is sold by Weiss Industries, Farmingdale, New York. One such system employs thermistors for sensing temperature network interface circuit, and includes a temperature display. Using this system allows for all of the fans to be factory installed and their speed controlled to maintain temperature.

A manually operated system may also be employed. Initially, all fans are adjusted to desired cabinet operating temperatures and after a short period of time are readjusted to achieve desired results. The temperatures in the cabinets are relatively stable and the display discussed above will warn of any changes needing correction, which will be infrequently.

The use of a structure that permits adjustment of the air flow insures that no more cool air is drawn through the cabinet then is necessary to produce the required cooling. If the heat load is very light no fans may be necessary, and all available openings, as will become apparent, remain in the form of perforated panels and air is in effect pumped through the cabinet by convention currents produced by the heat of the loads inside the cabinet. No opening to the cool air under the floor may be necessary. In prior art systems, as stated above, the electrically powered equipment in the cabinet is fed from an uninterruptable power source (UPS), backed up with direct current batteries. These UPS systems are very expensive and power consumption is carefully scheduled. It is an advantage of the present invention to have a convection cooling mode for the cabinet that does not require any UPS power. If the cooling load is greater, one fan may be employed, (an additional fan provides "N+1" redundant operation), together with the grommets adjusted to provide sufficient cooling air flow capacity from below the raised floor. In this manner the cooling requirement is satisfied while simultaneously using a minimum of power, raised floor cooling air flow and static pressure. If redundancy is required, for fault tolerance, an additional fan can be used simultaneously to serve a load. The fans have been sized to allow parallel operation of multiple fans. Solid side panels with grommeted holes for wires extending between adjacent cabinets prevent cooling air from short cycling from a heavily loaded cabinet that is adjacent to a lightly loaded cabinet that is adjacent to a lightly loaded, or empty cabinet. If the heat load is heavy fans may be added and the grommets may be opened further. In consequence of such an arrangement heat loads from 100 watts per cabinet up to over 6000 per cabinet may be accommodated.

An additional control is provided by a highly perforated front door of the cabinet. Air is drawn through the front door which is adapted to receive blank panels, so as to block air flow through various regions of the door whereby to control ambient air mixing with the cooling air. If fans are not used, the panels may not need to be inserted, although in some instances leaving part of the perforated opening obstructed may aid convention cooling. Research has proven that having the entire panel unobstructed hurts convection.

The ability to control the cooling effect as a function of heat load by adding or subtracting fans, varying the speed of the fans, controlling the grommets, and controlling flow through the front door without having to make any interior adjustments or changing basic structure provides a degree of flexibility not previously achievable. Concurrent maintainability is critical to the operators of these mission critical facilities.

Additional features of the system relate to the ability to make the changes with ease (concurrent maintainability). A preferably factory installed bottom shelf of the cabinet is located above the floor a distance that permits ready access to the grommets for adjustments to airflow or wire installations. Air flow blocking solid panels fit into spaces into the top that can otherwise receive panels having fans mounted thereon. Clearance bars residing just under the top of the cabinet prevent equipment from being inserted so close to the fans as to inhibit air flow. Additional adjustment is provided by the highly perforated front door and back panel, if convenient, of the cabinet. With a stand alone cabinet, the side panels may be perforated. Various tiles of the elevated access floor must be left out of the floor installation, saving floor costs and construction time so as to provide unimpeded access of the cabinet to the cooled air and wiring below the elevated floor. In addition, special fixtures are provided to prevent parts of the smaller floor panels from sliding under its associated cabinet, thereby impeding flow into the cabinet.

The above and other features insure that cooling under the floor is employed only when needed and only to the extent necessary to maintain the equipment in the cabinet within the desired temperature range for each piece of equipment. Thus, the desired objective to insure that cooling air and static pressure under the raised floor environment is not wasted by large cuts in the floor to access cables and provide enough space for a mechanic to work. Alternatively, when air is provided from overhead, the induction fans are used to efficiently cool the equipment without sub-cooling the front.

Another distinct advantage of the adjustable grommets is to provide room for a workman to install cables and conduits in the cabinet through the floor and then employ a rotating lid of the grommet for restricting airflow once the cables are installed. A snap in lid to prevent loss can be used, but can easily be removed if necessary for installation and repair work. If additional cooling is required, the grommets can be adjusted without having to move the cabinet.

There are installations in which the site is kept quite cool by air conditioning of the room and under floor cooling is not employed. In such an event the structure is raised above the floor and the access flooring is only used for power and network cabling, not cooling. Under these circumstances it is a violation of National Electric and National Fire Protection Codes to use the access floor for air distribution. The cabinet advantage here is that the induction fans on the top of the cabinet are used to draw room air in from the front, side or back perforated panels. Room air conditioning is used to supplement the ambient cooling effect of the air induced through the cabinet perforated panels. The grommets in the bottom plate remain closed except for those used for power or network cables. Once the wiring and cabling is installed, the grommets are closed down around the cables and wires to avoid wasting airflow from the induction fans and preventing a serious life-safety code violation by inducing airflow through the non-plenum rated access floor. A combination of induction induced flow and fan induced flow may be employed with one or both induced flows employed.

In other installations, the cabinet sits directly on the floor and the power and network cabling is run in cable trays overhead.

The enclosed cabinet concept has distinct advantages in these areas as one of the fan modules can be replaced with a grommet to allow overhead wiring to be routed down into the cabinet top and the grommet rotated to avoid the loss of airflow, while the remaining fan modules remain intact for cooling. If it is preferred to keep all fans in place, the wires can be brought into a fastened slot on the top of the cabinet, next to the fans. Again, room air, supplemented with room air conditioning units, provides the cooling as the room air is induced through the perforated panels of the cabinet. The cables and wiring may now be brought in through the top through a grommet or through a side wall. Convection cooling assists the cooling process; that is, it acts as a pump for moving cool air upward. Room air conditioning supplements the air in the room which is then drawn into the cabinet through the perforated front, side or back walls and directed to the computer equipment of the cabinet.

The concept of bringing in the cables etc. through the top wall may also be applied to the structure employing under floor cooling. One of the panels in the top wall may be replaced with a grommet to provide this feature.

In still another embodiment where under floor air is not employed for cooling but room air conditioning is. The cabinet sits above the floor and fans are inserted in the bottom as well as the top of the cabinet. Since the colder air always falls toward the floor, fans in the bottom of the cabinet blowing upward produce the greatest efficiency in the system.

If the room is air conditioned, take offs from overhead ducts can blow down directly into the cabinets while the fans in both the top and bottom of the cabinets draw air down through the cabinet; the fan on top being removed from the area of the incoming duct as far as the top of the cabinet permits.

The invention will now be further described by way of example with reference to the accompanying drawings in which:-
Figure 1 is an isometric view of a cabinet according to the present invention;
Figure 2 is a front view of the cabinet with blank panels installed behind the perforated front door of the cabinet;
Figure 3 illustrated the top surface of a cabinet providing for up to six spaces for blank panels or panels having fans mounted thereon or simply highly perforated panels;
Figure 4A-4D illustrates various configurations of panels that may be employed with the top surface of the cabinet illustrated in Figure 3;
Figure 5 illustrates the bottom panel of the cabinet with the grommets for controlling cold air flow into the cabinets, allowing wire to be pulled into the cabinet and subsequently closed around the wire to prevent the loss of cooling;
Figure 6 is a detailed view of one of the grommets;
Figure 7 illustrates the placement of the bottom shelf of the cabinet placed to permit access to the grommets;
Figure 8 is an isometric view of a perforated shelf employed in the present invention;
Figure 9 illustrates the arrangement of the cabinet on the floor tiles and the modification of the tiles to provide access for the cabinet to the cold air under the tiles;
Figure 10 is a front view in elevation of the placement of a cabinet over an open area of the access flooring installation providing access of the interior of the cabinet to the pressurized cold air;
Figure 11 illustrates a tile stop employed with the structure of Figure 9;
Figure 12 provides a detailed view of the use of the tile stop in conjunction with a factory supplied pre-cut tile;
Figure 13 illustrates the use of clearance bars to prevent blockage of the air flow through the top of the cabinet;
Figure 14 illustrates the entry of wires and cables into one cabinet and the passage of wires and solid cables into an adjacent cabinet through the solid side wall panels with grommeted holes for the wires;
Figure 15 illustrates an arrangement in which several cabinets are located side-by-side and cabling is brought into each cabinet from an overhead cable tray through grommets in the top wall that replace the panels illustrated in Fig. 1. One of the panels 12 of Fig. 1 is replaced by a grommet and wires and cables are or may be brought into the cabinet through that grommet in the top wall;
Figure 15A is a detailed view of the top of the cabinets of Fig. 15;
Figure 16 illustrates the structure when employed in a situation in which cooling air is not supplied under the floor;
Figure 17 illustrates a slide for controlling air flow through the door;
Figure 18 illustrates the overheat alarm;
Figure 18A illustrates the overheat alarm in detail; and
Figure 19 illustrates the use of overhead ducting to provide cool air to, or exhaust hot air from, the cabinet.

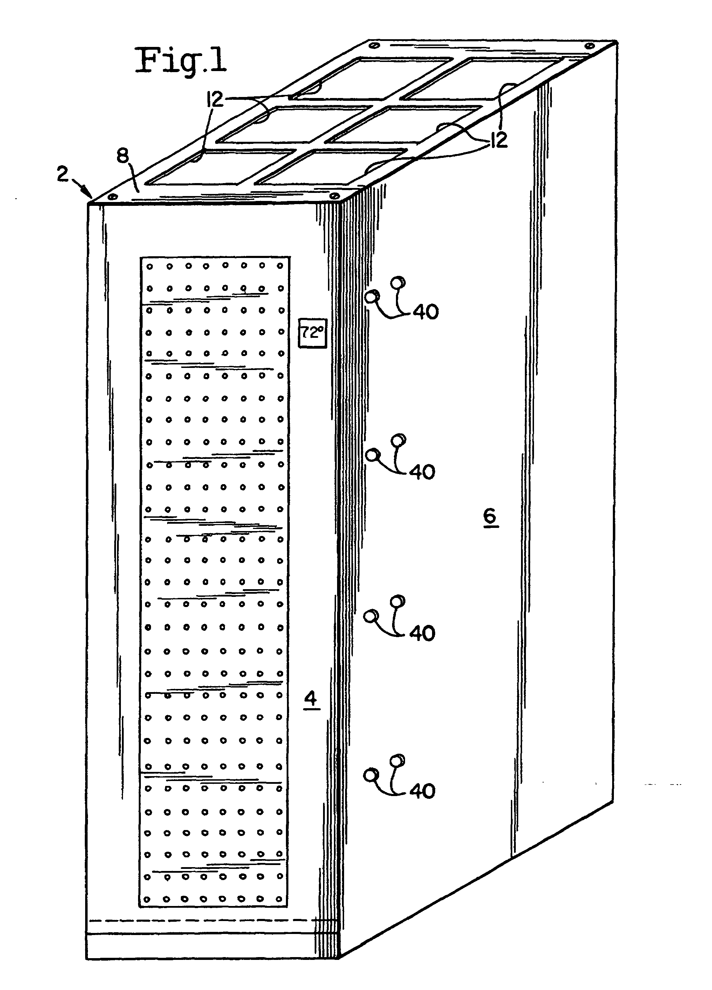

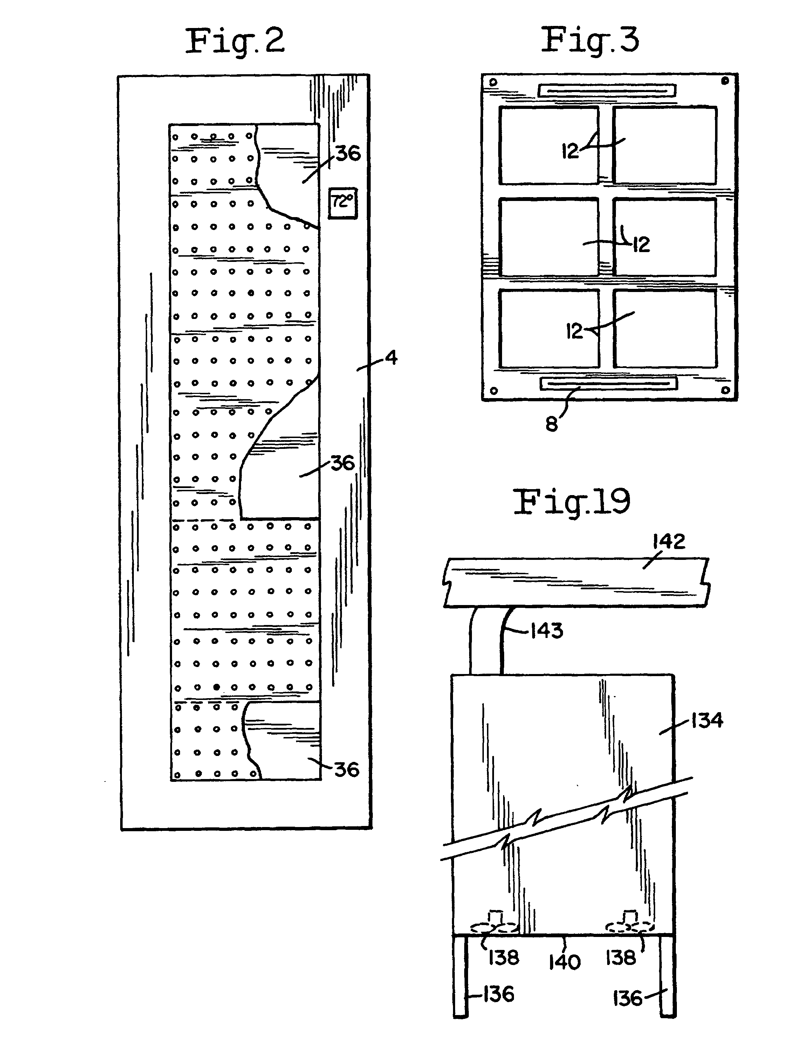

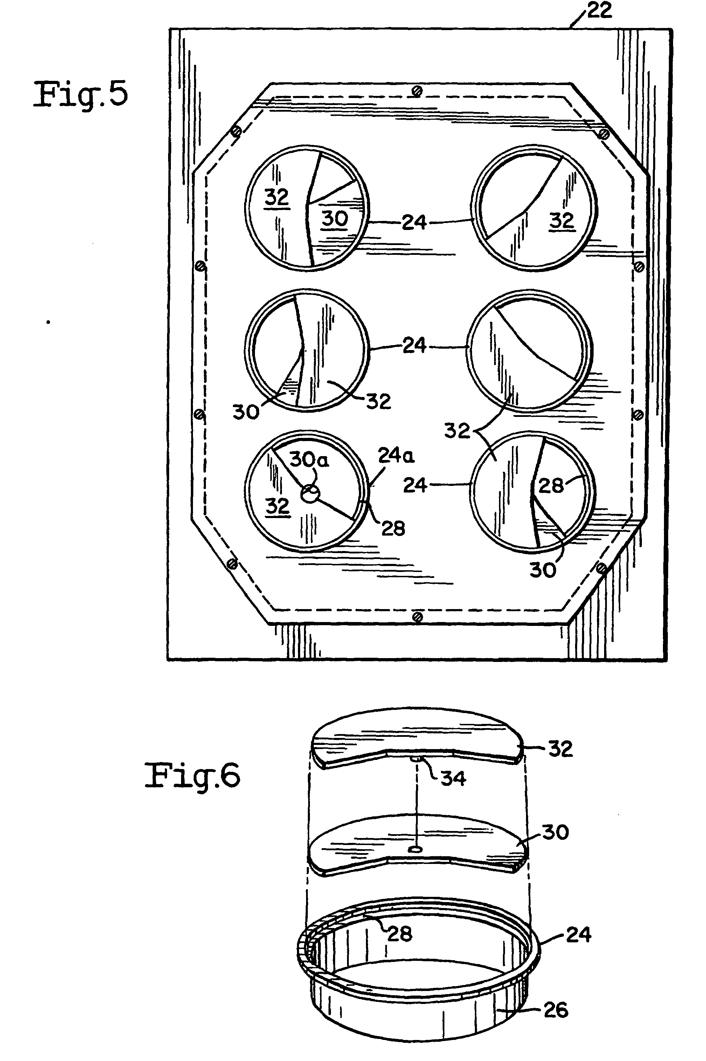

Referring now to Figures 1 and 2 of the accompanying drawings, a cabinet 2 has a highly perforated front door 4, side walls 6, only one of which is illustrated, and a back wall also not illustrated, a top wall 8, and a bottom wall 22 illustrated in Figure 5. It is to be noted that the back panel and in a stand alone environment the side panels may also be highly perforated.

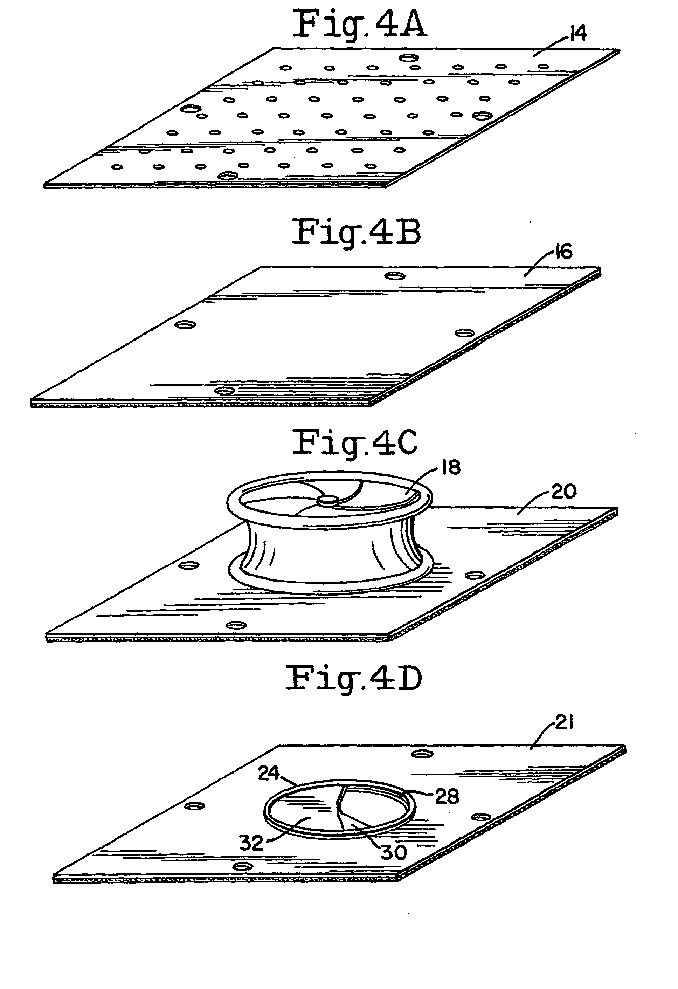

The top wall 8 has at least one or a number of openings 12 to receive panels with different configurations: a perforated panel 14 as shown in Figure 4A, a solid panel 16 as shown in Figure 4B, and a fan bearing panel 20 having a fan 18 mounted therein as shown in Figure 4C. Figure 4D illustrates a top view of a panel 21 with a variable opening panel grommet 24 in the top wall 8 to receive wires, if necessary.

The structure of top wall 8 is illustrated in greater detail in Figure 3, each opening 12 being approximately 8 1/2" deep x 11 1/8" wide in one embodiment of the invention. The highly perforated panel 14 is employed when a fan or fans are not used, panel 16 is used when a fan (or fans) is operating in one of the other openings and panel 20 is used to provide induced air flow through the cabinet.

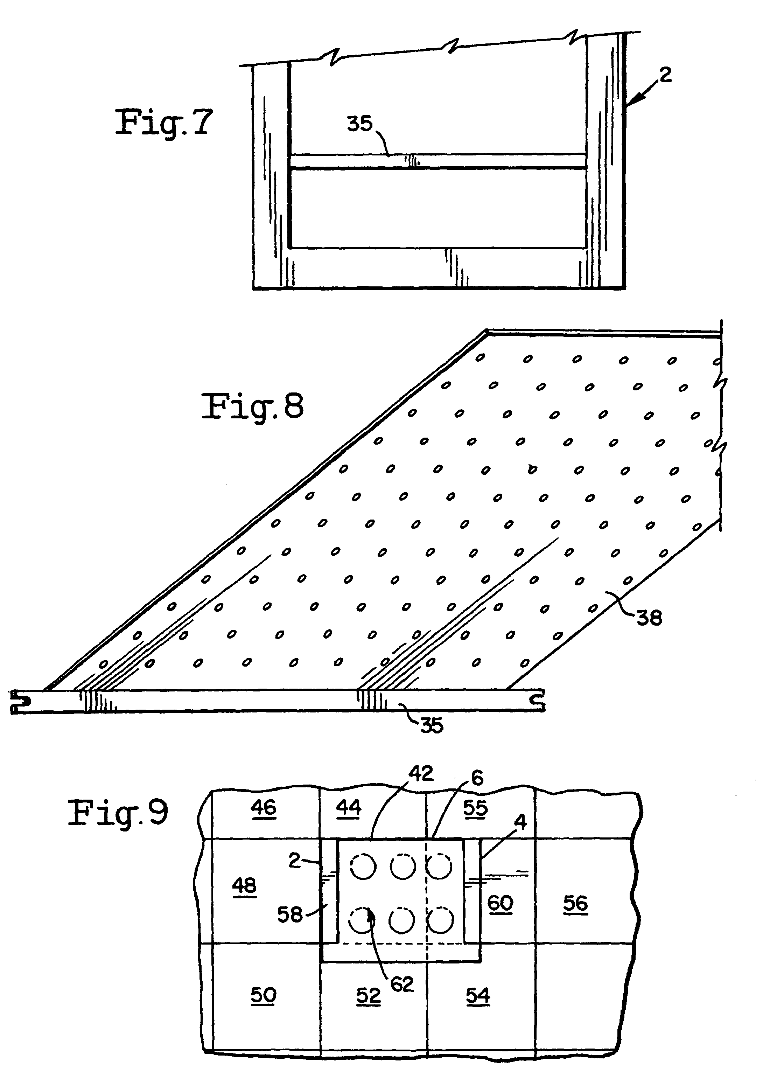

The bottom wall of the cabinet is illustrated in Figure 5 and is designated by reference numeral 22. The wall is illustrated as having six openings with a grommet 24 situated in each. Each grommet is adjustable to provide no opening, half opening with two blades, quarter opening with four blades, etc., in which it is situated. The grommet may be removed to provide full opening. Cables and wires may be brought into the cabinet through one of the grommets, grommet 24a in Fig. 5. Two plates 30 and 32, see Fig. 6 of the grommet 24a, one or both of which are notched at 30a, so that the wires and cables all fit in the hole thus provided and the grommet may be fully closed to prevent excessive flow of cool air out from under the floor.

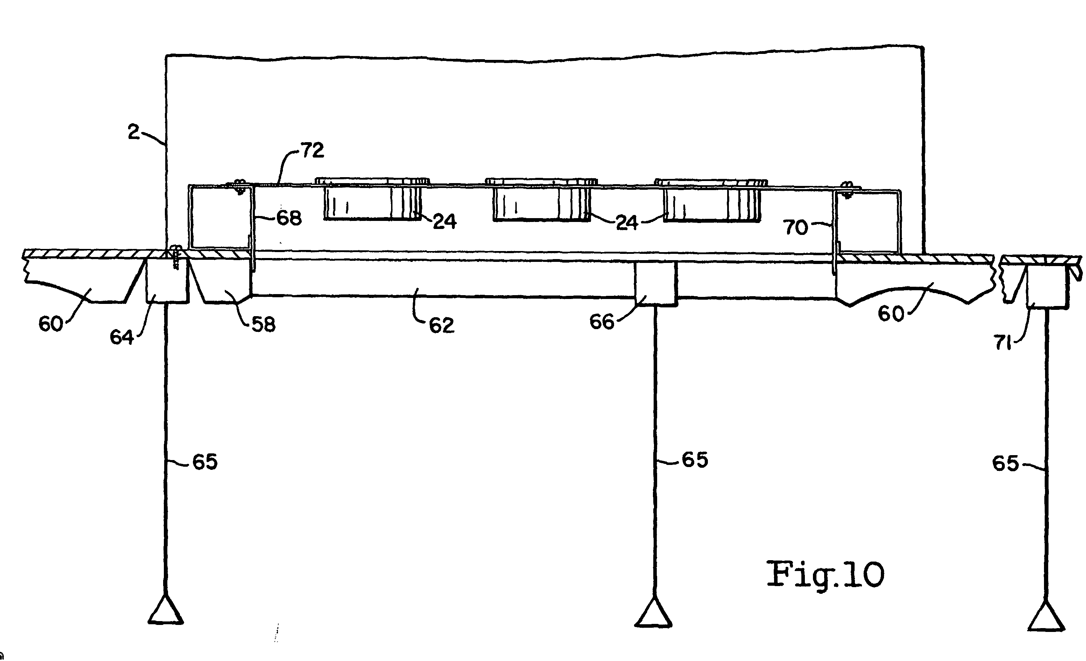

This same arrangement may be used for cables and wires brought in from the top. See Fig. 19. Referring to Figure 6, the grommet consists of an outer shell 26 that fits in a hole in the bottom of the cabinet. The shelf 26 has a shoulder 28 on which two disc shaped members 30 and 32 may be seated. The members rotate about a small pivot pin 34 that joins the two members. By rotating the members relative to one another the size of the opening may be controlled. Wiring for the components to be situated in the cabinet may be brought in through the opening provided by openings left in the access floor system that the cabinet is installed over as seen in Fig. 10. The grommets may be closed sufficiently to block all air except for leakage past the cables, and as indicated in Fig. 5, even that can be restricted to virtually nothing by conforming the blades to fit snugly about the wires and cables.

Referring to Figure 7, the cabinet 2 is illustrated as having a shelf 35 installed at the factory to prevent reduction of flow from below the floor by preventing any equipment being placed in that area at the same time the shelf provides uninhibited access to the grommets to permit adjustment as required. The gauge of the metal plate is such that a field cut slot such as slot 35 or 30a illustrated in Fig. 5 may be created for slipping the plate around existing wires, without disconnecting equipment. Referring to Fig. 7A, the shelf 35 is illustrated as having a slot for receiving cables and wires such as wires and cables 39.

The number of grommets and openings provided for panels in the top of the cabinet may be chosen to suit the needs of the system in which the apparatus is to operate. If the heat load is low, the grommets in the bottom of the cabinet may be closed and all of the top panel openings left open. Convection currents will bring air in through the front door to produce effective cooling. If the heat load is at a maximum, six fans may be used and the grommets in the bottom of the cabinet may be opened to the maximum extent. In this case one or more blank panels 36, see Figure 2, may be inserted behind the perforated door 4 to further to control air flow through the door. As indicated hereinbelow, in some embodiments of the invention air flow through the door is essential for proper operation and the blank panels are removed to permit maximum flow through the door.

Referring to Figure 8, as previously indicated, the shelves designated by the reference numeral 38 are perforated so that cooling air may flow freely about all surfaces of equipment resting on a shelf. As a typical example, the shelves may have as many as 75 perforations per square foot providing a 50% free area.

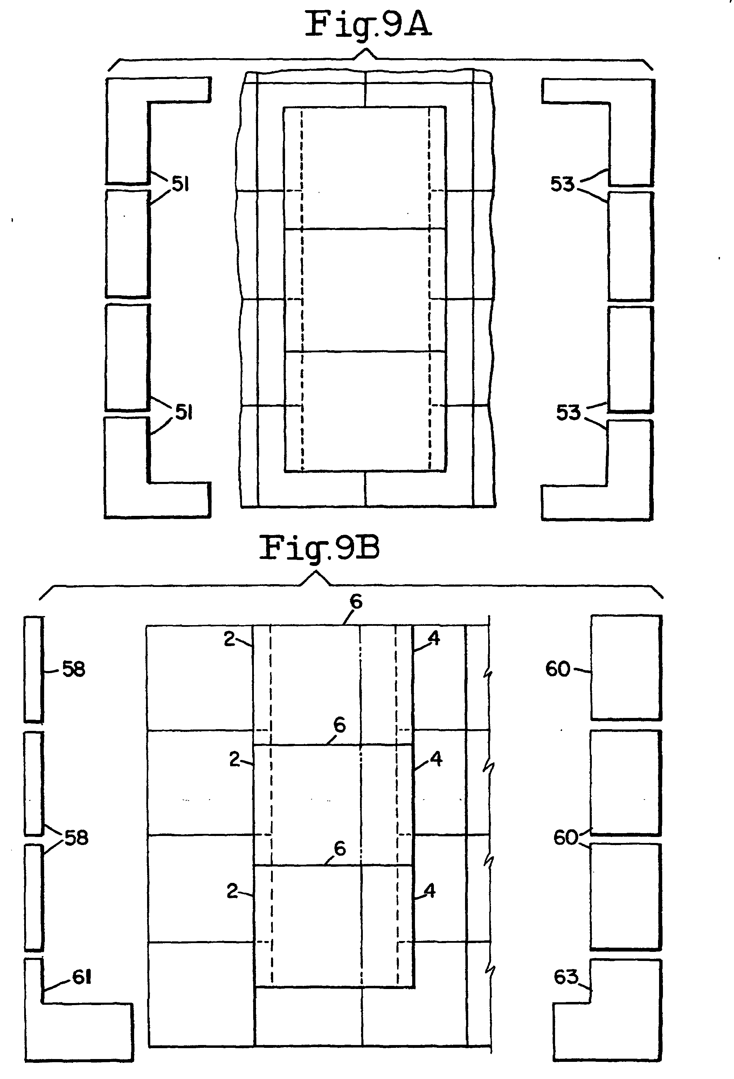

Referring to Figure 9 of the drawings, the cabinets are situated on the tiles in groups, side by side, with the sides of the cabinets in contact with one another, thus isolating each cabinet from each other cabinet and rendering control of air conditioning within a cabinet wholly under control of the controls for a cabinet. On the other hand, if desired, controls in adjacent cabinets may be interrelated by passage of wires between cabinets through the side walls. In some installations, the groups of cabinets can run 20 to 30 cabinets, all depending on the geometry of the room and other physical conditions. As becomes apparent subsequently, groups of six cabinets are preferred. Wires may be passed through the side walls from one cabinet to the other via holes 40 (see Fig. 1). A break between cabinets, about every 6 cabinets is to permit service personnel access to the cabinets and to minimize problems with locating cabinets and cutting tiles. The cabinets are located on the floor to allow the floor tile adjacent to the back of the cabinet to be lifted to permit access to the area under the tile and cabinet.

In a typical embodiment the cabinets are 36" by 28" on the floor, and each floor tile is 24" by 24". It is apparent that each cabinet is supported by several tiles. With these dimensions a group of six cabinets occupy exactly 7 tiles and as becomes apparent below no cutting of the tiles on the job is necessary. Referring again specifically to Fig. 9 of the accompanying drawings, there is illustrated the positioning of one cabinet on the tiles of the elevated floor.

The door 4 of the cabinet is to the right as viewed in Fig. 9, while the right side 6 of the cabinet sits approximately along the edge of 42 of the tiles labelled 44 and 55. As can be seen and discussed relative to Fig. 10, the right side of the cabinet is supported over a beam 62. The back wall of the cabinet 2 sits on a beam under tiles 46, 48 and 50. The cabinet sits on tiles 54 and 57. An important feature is that no cutting of tiles at the installation site is required since the factory supplied tiles 58 and 60 accommodate a cabinet to the floor and permit support to be provided by the floor support pedestals.

As can be seen in Fig. 9, the cabinet is supported on tiles 42, 52, 54 and tile 56 and partial factory supplied, tiles 58 and 60, for a total of two full tiles and two partial tiles. Previous installation practices require custom cutting of expensive floor tiles to provide an opening through the tiles into the region below the elevated floor. The present cabinet allows the floor tile manufacturer to precut 4" tile 58 and 16" by 24" panel 60 at the back and front of the cabinet. The structure discussed leaves a center opening 62 for access to the cold region below the tile. The horizontal depth of the opening, as viewed in Fig. 9, is 28" so that the access is 24" x 28" = 672 sq. inches or 4.67 sq. feet.

The fact that the plenum plate has the grommets for wiring and cooling allows installers to avoid custom cutting of holes in expensive floor tiles. According to the present invention, the floor is installed and the cabinet is simply set on top of open tile areas. A small amount of sealant is applied to the bottom of the cabinet and the cabinets are slid into place. Time and money that is required for design, floor installation and floor tile custom cut openings below the cabinets is reduced dramatically. Flexibility for moving cabinets in the future is maintained.

Figure 9A illustrates a conventional prior art approach to supporting a group of cabinets of the same size as those illustrated herein. Each cabinet is supported over two or more tiles. Tiles must be cut to properly support and position the cabinet over an opening. In Fig. 9A, the elements 51 along the left side of the Figure to elements 53 along the right side illustrates the remainder of the tiles after cutting to accommodate the cabinet.

Figure 9B illustrates an arrangement of tiles employing 8 tiles for support of 4 cabinets as described herein. The members 58 along the left side of the drawing are employed as illustrated in Fig. 9 and tiles 60 arrayed along the right side of the drawing are also as illustrated in Fig. 9. As can be seen in Fig. 9B custom cuts are required for support of a fourth cabinet of a group of 4. Tiles 61 and 63 have to be custom cut on the site.

If 6 cabinets are arrayed in a group, the width of the 6 cabinet array is 6 x 28 = 168". Each tile is 24" so 6 cabinets exactly equals 7 tiles. Thus, with the cabinets arrayed in groups of 6 no tile cutting is required on the job.

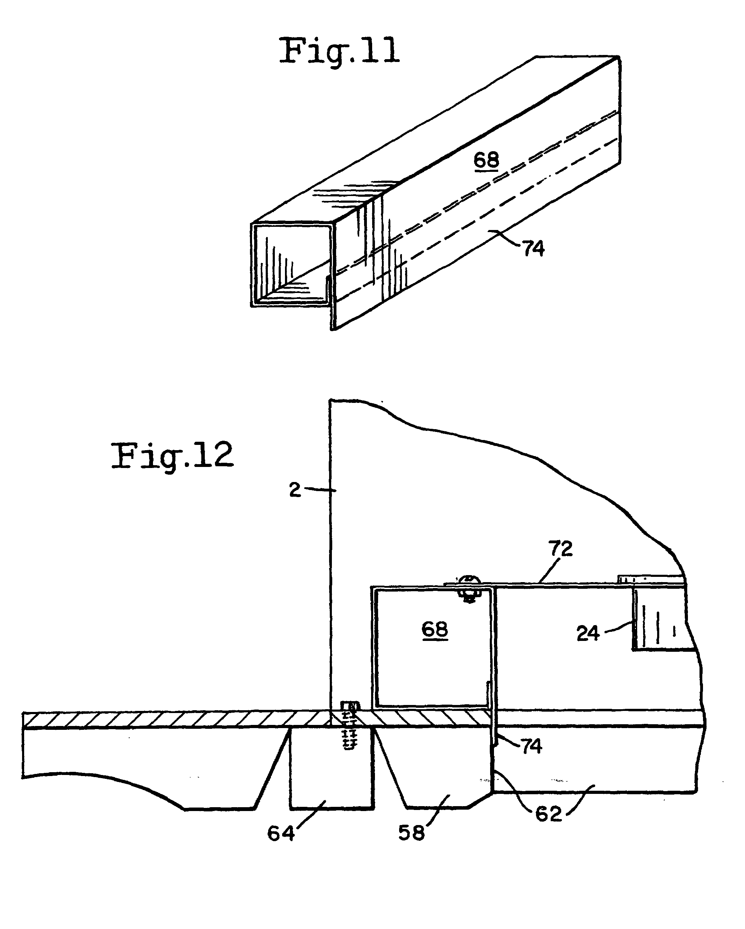

Referring now to Fig. 10 of the accompanying drawings the edges of the tiles in a standard elevated floor are supported on beams, reference numerals 64 and 66 (also known as "stringers") which beams are supported on pedestals 65. In the present invention the factory supplied partial tiles 58 and 60 are supported by beams 64 and 71 as illustrated in Fig. 10. To prevent the slabs 58 and 60 from sliding into the open space 62, tile stops 68 and 70 (see Figs. 11 and 12) are employed. Referring to tile stop 68, it is secured under and to the grommet board 72 of the cabinet. The cabinet is secured to the beam 64 with bolts or clamps via the bottom of a wall of the cabinet as viewed in Fig. 12. The tile stop has a downward extension 74 that is seated, as viewed in Figs. 10 and 12, along the edge of the slab 58. The cabinet is secured to the beam 64, the tile stop is secured to the grommet board 72 and the extension 74 prevents movement of the slab 58. Thus, the entire structure is integrated to insure that all elements of the structure remain in fixed position relative to one another. In this regard the group of cabinets, nine for instance, are all tied into the beams 64 and 66, and cannot move relative to one another.

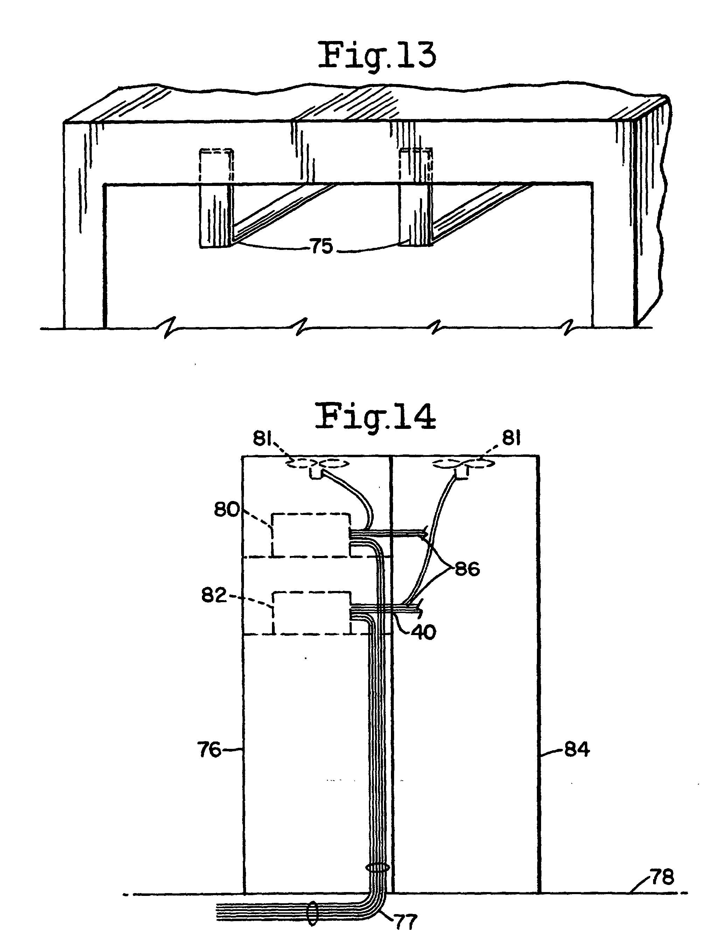

Referring now to Fig. 13, bars 75 are suspended from the top of the cabinet frame to prevent materials from being placed close enough to the top wall of the cabinet to impede flow of air through the top wall. Thus, steps are taken to insure unimpeded flow of air into and out of the cabinet.

Referring now to Fig. 14, there is schematically illustrated the entry of wires and cables into a cabinet and the passage of such wires and cables into the adjacent cabinet. Specifically, a cabinet 76 receives cables and wires 77 from under tile floor 78 through one of the grommets. See Fig. 5 for details. The wires and cables are connected to various pieces of equipment 80 and 82 and fans 81, and wires and cables 86 are taken from the equipment and incoming wires and cables into an adjacent cabinet 84. The cable openings 40 can be sealed tight about the wires and cables to prevent air flow from cabinet to cabinet.

As an example of one configuration, the solid wall panels between the cabinets have six two inch holes that are used to convey wire between adjacent cabinets without serious affecting cooling performance between a lightly loaded and heavily loaded equipment cabinet. Seating, if necessary, can be provided.

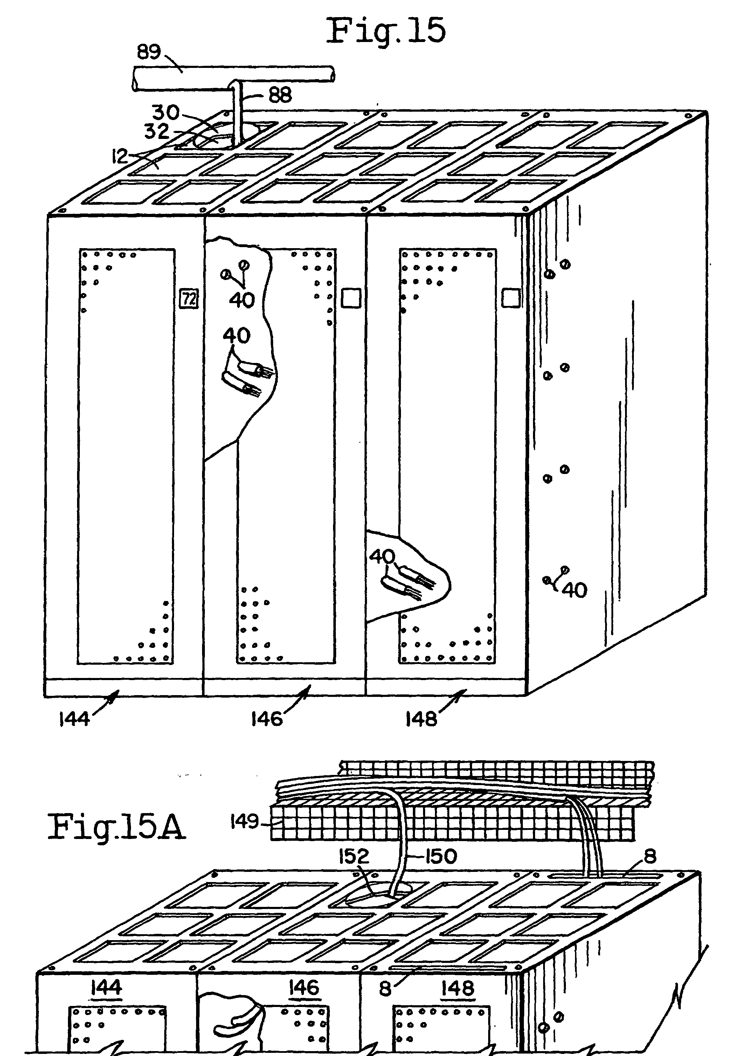

Referring now to Fig. 15 of the accompanying drawings, the apparatus of Fig. 1 is modified by replacing at least one of the panels 12 with a grommet bearing panel 32. If desirable, wires and cables 88 may be brought in from a cable tray or conduit 89 through such a grommet. The grommet in such case is of the configuration of grommet 24a illustrated in Fig. 5; that is, the plates of the grommet are notched to seal about the wires and cables 88. The grommet also provides control of air flow in and/or out through the top and multiple grommets may be used for this purpose. A gasketed slot can be used for wires instead of a grommet.

The arrangement of Fig. 15 illustrates three side-by-side cabinets 144, 146 and 148. Wires 88 as appropriate are passed from cabinet 144 through apertures 40 of the contacting side walls of the cabinets to the other cabinets 146 and 148 and others down the line if appropriate.

Fig. 15A provides a somewhat modified view of the top of the cabinets 144, 146 and 148. Cables and wires 150 are brought down from a cable tray 149 rather than a conduit as in Fig. 5, thus providing less complexity to these items. The wires and cables 150 extend into cabinet 146 through a grommet or gasketed slot 152 in the center cabinet 146 so that wires may extend in either or both directions into cabinets 144 and 148.

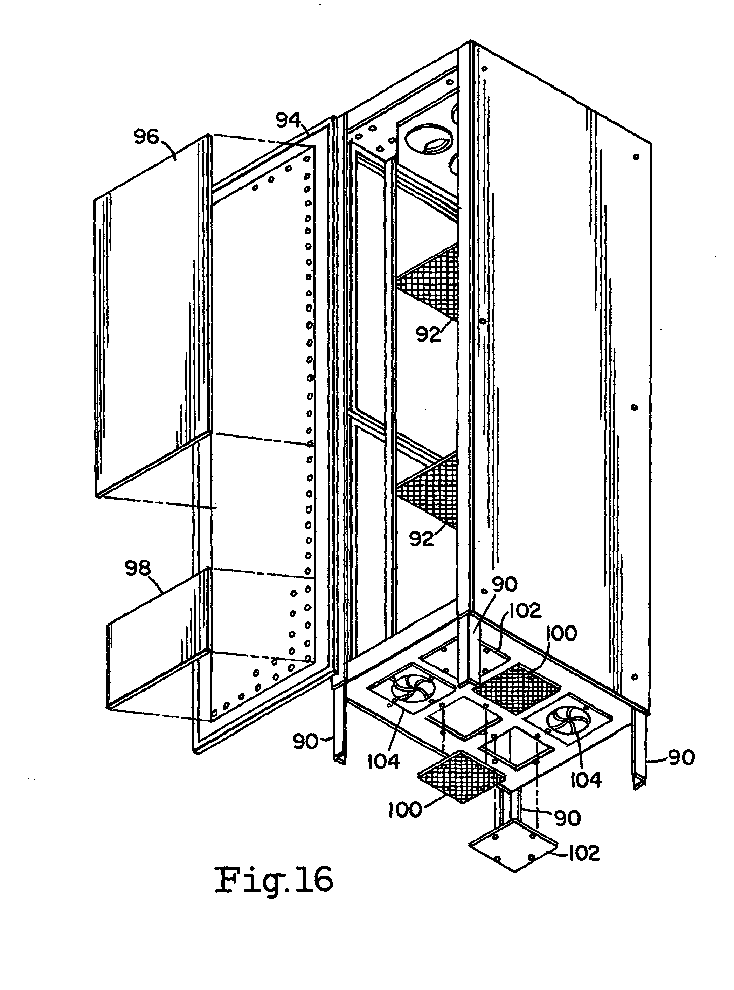

Referring now to Fig. 16, there is illustrated a modification of the structure to permit use with a solid floor and an air conditioned room.

The cabinet is used to induct ambient air that is supplementally cooled by a room air conditioning system through the perforated front, side, bottom or back panels and drawn up through the computer equipment by the top mounted induction fans. The basic structure of Fig. 1 can be stood on legs, directly on the floor, or the induction fans can be mounted in the bottom plate blowing up, if required by a particular installation. Such an arrangement is employed to take advantage of the maximum volume of cold air in the lower regions of the room. The legs are of a length to provide unimpeded flow of air in through the bottom wall; a foot to a foot and a half long legs are adequate.

The cabinet again has perforated shelves 92, a front door 94 and door inserts 96 to provide control of flow through a the highly perforated region of the door. The panel may be solid or perforated to varying degrees. Again, inserts at the bottom wall; such as, porous, solid or fan accommodating panels 100, 102 and 104, respectively may be provided.

Thus, the cabinet of Fig. 16 is essentially the same as the device of Fig. 1, but with legs.

As discussed in the introduction and above, in order to conserve cool air under the floor so as not to exceed the capacity of the air conditioner supplying the cool air under the floor, the system may be somewhat modified. In this arrangement reliance is placed on room air to produce the cooling; either normal room air or air conditioner cooling room air.

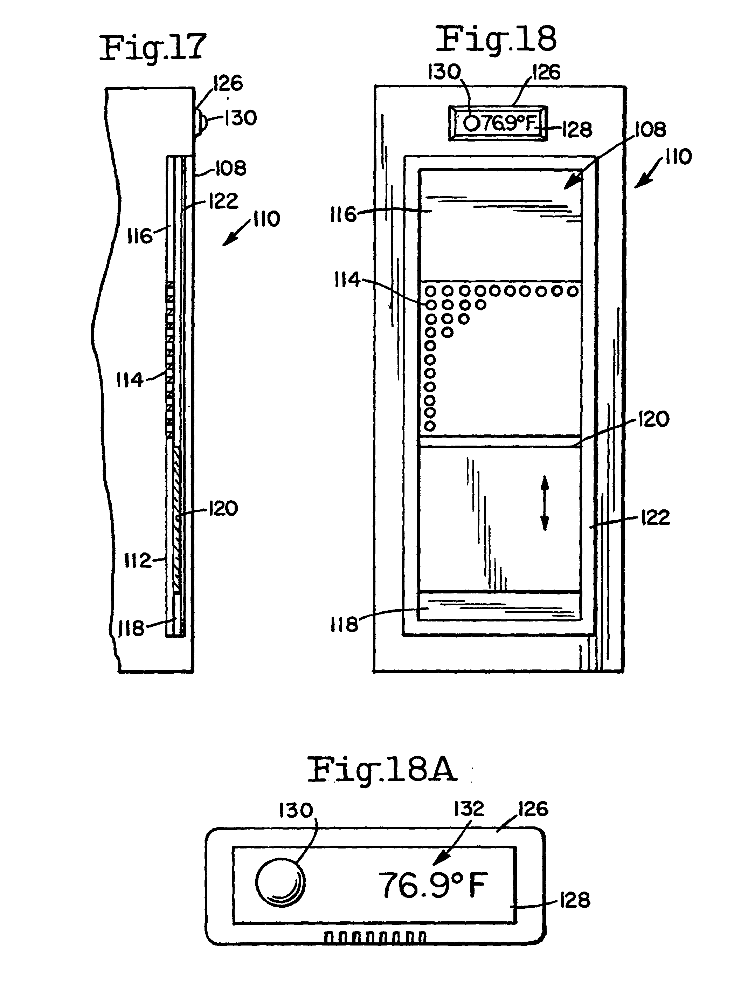

In one embodiment, no fans are used. Convection flow in the cabinet inducts sufficient room air to control temperature in the cabinet. In this instance a cabinet door such as illustrated in Fig. 17 may be employed. The door 108 to a cabinet 110 includes a panel 112 having a highly perforated central region 114 to solid top and bottom regions 116 and 118. A solid slide 120 in its uppermost position covers the perforated region of panel 112 and blocks air flow through the door. The panel 120 is illustrated in its lowermost position and exposes the perforations in the panel 112. The panel may be positioned to expose perforations 114 to varying degrees and thus control flow through the door. The panels and slide are retained by a further panel 122 that engages the edges of the panels.

The various panels are fabricated from clear plastic so that the interior of the cabinets are clearly visible.

Referring now to Fig. 18, there is illustrated the front of a cabinet showing the details of the slide 120 and its associated structure. The reference numerals of Fig. 17 are used in this Figure. The slide 120 is illustrated as partially depressed to expose the perforations 114 in panel 112. The panel 122 retains all elements in place.

Note at the top of the cabinet above the door 108, an opening 126 behind which is a temperature indicator 128 for the interior of the cabinet 110, together with a warming light 130. The light 130 sticks out of the cabinet, see Fig. 17, so that it may be observed from a wide range of positions in the room. If overheating occurs that light 130 will light up to indicate the overhead condition.

Referring to Figure 18A, the details of a unit 132 suitable for use in the cabinet is illustrated. The unit 132 includes a temperature sensing element, a thermistor, not illustrated. The unit 132 also provides a visual display 132 (liquid crystal) and is available from Weiss Instruments, Farmingdale, New York. Also, an audible alarm and an- integrated circuit to provide monitoring over a local area network of the Internet may be provided.

Referring now to Figure 19, an arrangement employing an overhead duct is provided. A cabinet(s) 134 stands on legs 136 and has fans 138 located in its bottom panel 140. The cabinet(s) is located under an overhead duct 142, which may be a cooling duct or an exhaust duct. If the duct is a cooling duct, the cool air is directed to the cabinet via a take-off duct 143. The fans 138 pulls the cool air down through the cabinet and cool the equipment therein.

If the duct 142 is part of an exhaust system, then the fans can produce upward flow to blow cool air up through the cabinet to cool as stated relative to Figure 16 and the heated air traverses duct 143 to exhaust duct 142.

It should be noted that the system illustrated is the inventor's early production design.

The cabinet is designed to accommodate equipment utilizing up to 7500 Watts of energy. Various modifications can be made in the equipment, and in particular the specific pieces of equipment specified herein. Once given the above disclosure, many other features, modifications and improvements will become apparent to the skilled artisan.

## Claims

1. A system for cooling an enclosure (2) containing heat producing elements, comprising:
said enclosure (2) having an interior compartment with a top wall (8), a bottom wall (22), and a shelf (35);
said bottom wall (22) having an aperture (24) with an adjustment mechanism (30, 32) adapted to control a size of said aperture (24);
said shelf (35) is adapted to be positioned within said enclosure (2) to prevent apparatus stored in said enclosure (2) from being placed in close proximity to said bottom wall (22) to hinder flow of cooling gas through said aperture (24) of said bottom wall (22) and to permit access to said aperture (24) of said bottom wall (22);
said top wall (8) having an aperture (12);
a panel (14, 16, 20, 21) adapted to be inserted into said top wall aperture (12);
said panel (14, 16, 20, 21) is adapted to control air flow through said top wall aperture (12);
a door (4) having an aperture; and
means (36) for controlling flow of air through said door (4).

2. The system of claim 1, further comprising a fan (18) adapted to be inserted into one of a plurality of apertures (24) of said top wall (8).

3. The system of claim 2, wherein said fan (18) is a variable speed fan.

4. The system of claim 2 or 3, further comprising means to limit power consumption of said fan (18) to less than 10 % of power consumed by equipment adapted to be placed in said enclosure.

5. The system of claim 1, wherein said panel (14, 16, 20, 21) is selected from the group consisting of a perforated panel (14), a solid panel (16) a panel (20) with a fan (18) mounted therein, and a panel (21) with a variable opening (24).

6. The system of claim 1, 2 or 4 further comprising a side wall (6) between adjacent enclosures (144, 146, 148) and said side wall (6) having an aperture (40) to enable passage of wires (86) between adjacent enclosures (144, 146, 148).

7. The system of claim 1, 2, 3 or 6 wherein said aperture (24) of said bottom wall (22) is adapted to receive a communication cable (77).

8. The system of claims 1, 2, 4, 6 or 7, wherein said aperture (24) of said bottom wall (22) is adapted to be closed to prevent flow of air through a floor adapted to support said enclosure (2).

9. The system of claim 1, further comprising an elevated floor of tiles (78) having cooling air thereunder under pressure and a plurality of arrayed enclosures (144, 146, 148) arranged on said tiles in groups of predetermined quantities with their side walls in contact.

10. The system of claims 1, 2, 7, 8 or 9, further comprising means (18) for regulating introduction of cooling air into said enclosures (2) through said bottom wall (22).

11. The system of claims 1, 8, 9 or 10 wherein said floor includes an opening (24) therethrough to permit access to cool air under said tiles (78).

12. The system of claim 1, further comprising raised floor tiles (78) adapted to receive said bottom wall (22) of said enclosure (2).

13. The system of claim 12, wherein said tiles (78) include members adapted to provide an opening (24) under said bottom wall (22), wherein said opening (24) is in communication with an interior portion of said enclosure (2).

14. The system of claims 1, 4, 6, 7, 8 or 9 wherein said aperture (24) of said bottom wall (22) is adapted to introduce gas into said enclosure to enhance cooling produced by convection.

15. The system of claims 2 or 4, wherein said fan (18) is located in said enclosure (2) to establish a flow pattern in said enclosure (2) to enable gas entering through said door (4) to move uniformly upward through said top wall (8) under the influence of said fan (18) to produce effective convection cooling.

16. The system of claims 1, 2, 4 or 9 wherein said enclosure (2) is adapted to accommodate equipment utilizing up to 7500 watts of energy.

17. The system of claim 1, wherein said air flow control means is a solid panel (36) adapted to be selectively insertable into said door (4) to control flow of gas there through.

18. The system of claim 1, further comprising means (18) for mixing ambient air entering through said door (4) with a predetermined quantity of cool air from under a shelf (35) in close proximity to said bottom wall (22), wherein said mixing means (18) is adapted to establish a predetermined temperature in said enclosure for a predetermined heat load.

19. The system of claim 18, wherein said mixing means (18) is adapted to mix sources of air to maintain a desired temperature received from the group consisting of: a quantity of panels (14, 16, 20, 21) in said top wall (8), the number of fans (18) in said top wall apertures (12), the speed of the fans, the number and size of openings in the floor, and the number of blocking panels (36) in the door (4).

## Patentansprüche

1. System zum Kühlen einer wärmeerzeugende Elemente enthaltenden Einschließung (2) mit den folgenden Merkmalen:
die Einschließung (2) weist ein inneres Abteil mit einer oberen Wand (8), einer unteren Wand (22) und einem Bord (35) auf;
die obere Wand (22) weist eine Öffnung (24) mit einem Einstellmechanismus (30, 32), der dazu ausgelegt ist, die Größe der Öffnung (24) zu steuern, auf;
das Bord (35) ist dazu ausgelegt, innerhalb der Einschließung (2) positioniert zu werden, um zu verhindern, dass eine in der Einschließung (2) aufbewahrte Vorrichtung in unmittelbarer Nähe zu der unteren Wand (22) platziert wird, was die Strömung von Kühlgas durch die Öffnung (24) der unteren Wand (22) behindert, und um Zugang zu der Öffnung (24) der unteren Wand (22) zu gewährleisten;
die obere Wand (8) weist eine Öffnung (12) auf;
ein Einschubelement (14, 16, 20 21) ist dazu ausgelegt, in die Öffnung (12) der oberen Wand eingefügt zu werden;
das Einschubelement (14, 16, 20, 21) ist dazu ausgelegt, die Luftströmung durch die Öffnung (12) der oberen Wand zu steuern;
eine Tür (4) weist eine Öffnung auf; und
eine Einrichtung (36) zum Steuern der Luftströmung durch die Tür (4).

2. System nach Anspruch 1, weiterhin aufweisend einen Ventilator (18), der dazu ausgelegt ist, in eine von mehreren Öffnungen (24) in der oberen Wand (8) eingefügt zu werden.

3. System nach Anspruch 2, wobei der Ventilator (18) ein Ventilator mit variabler Geschwindigkeit ist.

4. System nach Anspruch 2 oder 3, weiterhin aufweisend eine Einrichtung zur Begrenzung des Energieverbrauchs des Ventilators (18) auf weniger als 10 % derjenigen Energie, die von der Einrichtung verbraucht wird, die dazu ausgelegt ist, in der Einschließung platziert zu werden.

5. System nach Anspruch 1, wobei das Einschubelement (14, 16, 20, 21) ausgewählt ist aus der Gruppe bestehend aus einem perforierten Einschubelement (14), einem massiven Einschubelement (16), einem Einschubelement (20) mit einem darin angeordneten Ventilator (18), und einem Einschubelement (21) mit einer variablen Öffnung (24).

6. System nach Anspruch 1, 2 oder 4, weiterhin aufweisend eine Seitenwand (6) zwischen benachbarten Einschließungen (144, 146, 148) und wobei die Seitenwand (6) eine Öffnung (40) aufweist, um den Durchtritt von Kabeln (86) zwischen benachbarten Einschließungen (144, 146, 148) zu ermöglichen.

7. System nach Anspruch 1, 2, 3 oder 6, wobei die Öffnung (24) der unter Wand (22) dazu ausgelegt ist, ein Kommunikationskabel (77) aufzunehmen.

8. System nach Anspruch 1, 2, 4, 6 oder 7, wobei die Öffnung (24) der unteren Wand (22) dazu ausgelegt ist, verschlossen zu werden, um Luftströmung durch einen Boden zu verhindern, der dazu ausgelegt ist, die Einschließung (2) zu tragen.

9. System nach Anspruch 1, weiterhin umfassend einen erhobenen Boden aus Platten (78), unter denen sich Kühlluft unter Druck befindet, sowie eine Vielzahl von angeordneten Einschließungen (144, 146, 148), die auf den Platten in Gruppen vorbestimmter Anzahl angeordnet sind, wobei ihre Seitenwände einander berühren.

10. System nach Anspruch 1, 2, 7, 8 oder 9, weiterhin umfassend eine Einrichtung (18) zum Regulieren der Einführung von Kühlluft in die Einschließung (2) durch die unteren Wände (22).

11. System nach Anspruch 1, 8, 9 oder 10, wobei der Boden eine Öffnung (24) aufweist, um den Zustrom von Kühlluft unter den Platten (78) zu ermöglichen.

12. System nach Anspruch 1, weiterhin umfassend erhobenen Bodenplatten (78), die dazu ausgelegt sind, die untere Wand (22) der Einschließung (2) aufzunehmen.

13. System nach Anspruch 12, wobei die Platten (78) Elemente aufweisen, die dazu ausgelegt sind, eine Öffnung (24) unter der unteren Wand (22) bereitzustellen, wobei die Öffnung (24) mit einem inneren Bereich der Einschließung (2) in Verbindung steht.

14. System nach Anspruch 1, 4, 6, 7, 8 oder 9, wobei die Öffnung (24) der unteren Wand (22) dazu ausgelegt ist, Gas in die Einschließung einzuführen, um die durch Konvektion erzeugte Kühlung zu erhöhen.

15. System nach Anspruch 2 oder 4, wobei der Ventilator (18) in der Einschließung (2) angeordnet ist, um ein Strömungsmuster in der Einschließung (2) zu erzeugen, um es zu ermöglichen, dass Gas durch die Tür (4) eintritt, um gleichförmig nach oben durch die obere Wand (8) zu strömen unter dem Einfluss des Ventilators (18), um eine wirksame Konvektionskühlung zu erzeugen.

16. System nach Anspruch 1, 2, 4 oder 9, wobei die Einschließung (2) dazu ausgelegt ist, eine Einrichtung aufzunehmen, welche bis zu 7500 Watt an Energie verbraucht.

17. System nach Anspruch 1, wobei die Luftströmungssteuereinrichtung ein massives Einschubelement (36) ist, dass dazu ausgelegt ist, selektiv in die Tür (4) eingeschoben zu werden, um Gasströmung durch diese hindurch zu steuern.

18. System nach Anspruch 1, weiterhin umfassend eine Einrichtung (18) zum Mischen von Umgebungsluft, die durch die Tür (4) eintritt, mit einer vorbestimmte Menge von Kühlluft von unterhalb eines Bords (35) in unmittelbarer Nähe zu der unteren Wand (22), wobei die Mischeinrichtung (18) dazu ausgelegt ist, eine vorbestimmte Temperatur in der Einschließung für eine vorbestimmte Wärmebelastung herzustellen.

19. System nach Anspruch 18, wobei die Mischeinrichtung (18) dazu ausgelegt ist, zur Aufrechterhaltung einer gewünschten Temperatur Luftquellen zu mischen von der Gruppe bestehend aus: einer Anzahl Borde (14, 16, 20, 21) in der oberen Wand (8), der Anzahl von Ventilatoren (18) in der Öffnung (12) der oberen Wand, der Geschwindigkeit der Ventilatoren, der Anzahl und Größe von Öffnungen in dem Boden, und der Anzahl von Sperrborden (36) in der Tür (4).

## Revendications

1. Système de refroidissement pour un boîtier (2) contenant des éléments produisant de la chaleur, comprenant:
ledit boîtier (2) ayant un compartiment intérieur avec une paroi supérieure (8), une paroi inférieure (22) et un rayon (35);
ladite paroi inférieure (22) ayant une ouverture (24) avec un mécanisme d'ajustage (30,32) agencé de façon à contrôler une mesure de ladite ouverture (24);
ledit rayon (35) étant agencé de façon à être positionné dans ledit boîtier (2) pour prévenir que des appareils logés dans ledit boîtier (2) seraient disposés en proximité immédiate de ladite paroi inférieure (22) pour empêcher l'écoulement du gaz de refroidissement à travers ladite ouverture (24) de ladite paroi inférieure (22) et permettre l'accès à ladite ouverture (24) de ladite paroi inférieure (22);
ladite paroi supérieure (8) ayant une ouverture (12);
un panneau (14, 16, 20, 21) agencé de façon à être inséré dans ladite ouverture (12) de la paroi supérieure;
ledit panneau (14, 16, 20, 21) étant agencé de façon à contrôler l'écoulement de l'air à travers ladite ouverture (12) de la paroi supérieure;
une porte (4) ayant une ouverture; et
un moyen (36) pour contrôler l'écoulement de l'air à travers ladite porte (4).

2. Le système selon la revendication 1, comprenant en outre un ventilateur (18) agencé de façon à être inséré dans une de plusieurs ouvertures (24) de ladite paroi supérieure (8).

3. Le système selon la revendication 2, dans lequel ledit ventilateur (18) est un ventilateur à vitesse variable.

4. Le système selon la revendication 2 ou 3, comprenant en outre un moyen pour limiter la consommation d'énergie dudit ventilateur (18) à moins de 10% de l'énergie consommée par des dispositifs agencés de façon à être disposés dans ledit boîtier.

5. Le système selon la revendication 1, dans lequel ledit panneau (14, 16, 20, 21) est choisi parmi un groupe consistant en un panneau perforé (14), en un panneau solide (16), en un panneau (20) avec un ventilateur (18) monté dans le même, et en un panneau (21) avec une ouverture variable (24).

6. Le système selon la revendication 1, 2 ou 4 comprenant en outre une paroi latérale (6) entre des boîtiers adjacents (144, 146, 148), ladite paroi latérale (6) ayant une ouverture (40) pour permettre le passage des fils (86) entre des boîtiers adjacents (144, 146, 148).

7. Le système selon la revendication 1, 2, 3 ou 6 dans lequel ladite ouverture (24) de ladite paroi inférieure (22) est agencée de façon à recevoir un câble de connexion (77).

8. Le système selon les revendications 1, 2, 4, 6 ou 7 dans lequel ladite ouverture (24) de ladite paroi inférieure (22) est agencée de façon à être fermée pour prévenir l'écoulement d'air à travers un fond agencé de façon à porter ledit boîtier (2).

9. Le système selon la revendication 1, comprenant en outre un fond élevé de dalles (78) ayant de l'air de refroidissement étant sous pression en dessous et une pluralité de boîtiers (144, 146, 148) alignés arrangés sur lesdites dalles en des groupes en quantités prédéterminées, leurs parois latérales étant en contact.

10. Le système selon les revendications 1, 2, 7, 8 ou 9 comprenant en outre un moyen (18) pour régler l'introduction de l'air de refroidissement dans lesdits boîtiers (2) à travers ladite paroi inférieure (22).

11. Le système selon les revendications 1, 8, 9 ou 10 dans lequel ledit fond comprend une ouverture (24) le traversant pour permettre l'accès de l'air de refroidissement sous lesdites dalles (78).

12. Le système selon la revendication 1, comprenant en outre des dalles (78) du fond surélevé agencées de façon à recevoir ladite paroi inférieure (22) dudit boîtier (2).

13. Le système selon la revendication 12, dans lequel lesdites dalles (78) comprennent des membres agencés de façon à créer une ouverture (24) en dessous de ladite paroi inférieure (22), ladite ouverture (24) communiquant avec une portion intérieure dudit boîtier (2).

14. Le système selon les revendications 1, 4, 6, 7, 8 ou 9 dans lequel ladite ouverture (24) de ladite paroi inférieure (22) est agencée de façon à pouvoir introduire du gaz dans ledit boîtier pour produire un refroidissement par convection.

15. Le système selon les revendications 2 ou 4, dans lequel ledit ventilateur (18) est disposé dans ledit boîtier (2) pour créer une configuration d'écoulement dans ledit boîtier (2) afin que le gaz entrant par ladite porte (4) puisse se mouvoir uniformément vers le haut à travers ladite paroi supérieure (8) sous l'influence dudit ventilateur (18) pour produire un refroidissement effectif par convection.

16. Le système selon les revendications 1, 2, 4 ou 9 dans lequel ledit boîtier (2) est agencé de façon à recevoir des équipements jusqu'à une énergie de 7500 watts.

17. Le système selon la revendication 1, dans lequel ledit moyen de contrôle de l'écoulement de l'air est un panneau solide (36) agencé de façon à être insérable sélectivement dans ladite porte (4) pour contrôler l'écoulement du gaz à travers celle-ci.

18. Le système selon la revendication 1 comprenant en outre un moyen (18) pour mélanger de l'air ambiant entrant par ladite porte (4) avec une quantité prédéterminée d'air froid provenant du dessous d'un rayon (35) en proximité immédiate de ladite paroi inférieure (22), ledit moyen de mélange (18) étant agencé de façon à établir une température prédéterminée dans ledit boîtier pour un chargement de chaleur prédéterminé.

19. Le système selon la revendication 18, dans lequel ledit moyen de mélange (18) est agencé de façon à mélanger des sources d'air pour maintenir une température désirée reçue par le groupe consistant en: une quantité de panneaux (14, 16, 20, 21) dans ladite paroi supérieure (8), le nombre de ventilateurs (18) dans lesdites ouvertures (12) dans la paroi supérieure, la vitesse des ventilateurs, le nombre et la mesure des ouvertures dans le fond, et le nombre de panneaux de blocage (36) dans la porte (4).
